(19) Europäisches Patentamt
European Patent Office
Office européen des brevets

(11) **EP 4 694 582 A1**

(12) **EUROPEAN PATENT APPLICATION**
published in accordance with Art. 153(4) EPC

(43) Date of publication:
**11.02.2026 Bulletin 2026/07**

(21) Application number: **24800171.1**

(22) Date of filing: **08.04.2024**

(51) International Patent Classification (IPC):
*H05K 1/02* (2006.01)      *H05K 1/11* (2006.01)
*H05K 3/46* (2006.01)      *H01P 1/201* (2006.01)

(52) Cooperative Patent Classification (CPC):
**H01P 1/201; H05K 1/02; H05K 1/11; H05K 3/46**

(86) International application number:
**PCT/KR2024/004653**

(87) International publication number:
**WO 2024/228483 (07.11.2024 Gazette 2024/45)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **01.05.2023   KR 20230056788
01.06.2023   KR 20230070786**

(71) Applicant: **Samsung Electronics Co., Ltd.
Suwon-si, Gyeonggi-do 16677 (KR)**

(72) Inventor: **PARK, Sungwon
Suwon-si Gyeonggi-do 16677 (KR)**

(74) Representative: **Gulde & Partner
Patent- und Rechtsanwaltskanzlei mbB
Berliner Freiheit 2
10785 Berlin (DE)**

(54) **ELECTRONIC DEVICE TO WHICH COPLANAR WAVEGUIDE STRUCTURE IS APPLIED**

(57)    Disclosed is a coplanar waveguide structure which can be applied to a transmission line in an electronic device. In an electrical wiring of a printed circuit board in the electronic device, a first signal wiring, which starts from a first electrical contact, can be branched into at least two signal wirings at a first junction so as to be extended to second signal wirings of a flexible part. One end of a first ground wiring arranged between the second signal wirings can be ground-connected to a different conductor layer through a first via-hole penetrating a dielectric at a first rigid part.

*FIG.4*

EP 4 694 582 A1

## Description

### [Technical Field]

The disclosure relates to a coplanar waveguide (CPW) structure that may be applied for transmission lines in an electronic device.

### [Background Art]

An electronic device may be integrated to have electronic components or electronic parts such as resistors, inductors, capacitors, diodes, or transistors, or integrated circuits (IC) efficiently arranged in a limited inner space. For example, an electronic device may have a printed circuit board (PCB) designed so that electronic components may be soldered or bonded.

The electronic device may implement a transmission line for electrical connection between components or PCBs mounted with components using a flexible printed circuit board (FPCB).

In the electronic device, when impedance matching between components and transmission lines is not achieved, return loss or insertion loss in the transmission line may increase.

### [Disclosure of Invention]

### [Solution to Problems]

According to an embodiment of the disclosure, an electronic device may include a printed circuit board 400 including at least one conductor layer configured such that a first rigid part and a second rigid part are disposed on two opposite sides with a flex part therebetween.

According to an embodiment, an electrical line may be configured in the at least one conductor layer to enable signal transmission between a first electrical contact point provided in the first rigid part for electrical connection to a first external element and a second electrical contact point provided in the second rigid part for electrical connection to a second external element.

According to an embodiment, the electrical line may be configured such that a first signal line starting from the first electrical contact point branches into at least two at a first junction and extends to second signal lines of the flex part, and one end of a first ground line disposed between the second signal lines is ground-connected to another conductor layer through a first via hole penetrating a dielectric in the first rigid part.

According to an embodiment of the disclosure, a rigid/flexible printed circuit board included in an electronic device may include a first rigid printed circuit board including a first conductor layer configured such that a signal line extending from a first terminal branches into two first signal lines at a first junction, a second rigid printed circuit board including a second conductor layer configured such that a signal line extending from a second terminal branches into two second signal lines at a second junction, and a flexible printed circuit board including a third conductor layer having a transmission line configured to electrically connect the first conductor layer and the second conductor layer in a coplanar manner.

According to an embodiment of the disclosure, the third conductor layer of the flexible printed circuit board included in the rigid/flexible printed circuit board of the electronic device may be configured to include two third signal lines provided to electrically connect the two first signal lines to the two second signal lines in one-to-one correspondence, an inner ground line disposed parallel while maintaining a predetermined spacing between the two third signal lines, a first outer ground line disposed parallel to the inner ground line while maintaining a predetermined spacing with one of the two third signal lines therebetween, and a second outer ground line disposed parallel to the inner ground line while maintaining a predetermined spacing with another one of the two third signal lines therebetween.

### [Brief Description of Drawings]

FIG. 1 is a block diagram illustrating an electronic device in a network environment according to various embodiments.

FIG. 2 is a view illustrating an application example of a rigid/flexible printed circuit board (RF PCB) in an electronic device according to an embodiment of the disclosure.

FIG. 3 is a view illustrating a coplanar waveguide (CPW) structure that may be applied to a conductor layer of a printed circuit board (PCB) in an electronic device according to an embodiment of the disclosure.

FIG. 4 is a structural diagram illustrating a coplanar waveguide (CPW) applied to a rigid/flexible printed circuit board (RF PCB) in an electronic device according to an embodiment of the disclosure.

FIG. 5 is a structural diagram illustrating a part where line of a rigid part and line of a flex part are connected in a transmission line of an electronic device according to an embodiment of the disclosure.

FIG. 6 is a view illustrating an example of capacitance formation between transmission lines provided in a flex part in an electronic device according to an embodiment of the disclosure.

FIG. 7A or FIG. 7B is a view illustrating an example of surface current flowing in line in a general coplanar waveguide (CPW) structure.

FIG. 8A or FIG. 8B is a view illustrating an example of surface current flowing in line in a coplanar waveguide (CPW) structure according to an embodiment of the disclosure.

FIG. 9 is an example view illustrating a rigid/flexible printed circuit board (RF PCB) applied to an electronic device according to an embodiment of the disclosure.

In relation to the description of the drawings, identical or similar reference numerals may be used for identical or similar components.

**[Mode for the Invention]**

Hereinafter, embodiments of the disclosure are described in detail with reference to the drawings so that those skilled in the art to which the disclosure pertains may easily practice the disclosure. However, the disclosure may be implemented in other various forms and is not limited to the embodiments set forth herein. The same or similar reference denotations may be used to refer to the same or similar elements throughout the specification and the drawings. Further, for clarity and brevity, no description is made of well-known functions and configurations in the drawings and relevant descriptions.

An embodiment of the disclosure may provide a coplanar waveguide (CPW) structure for impedance matching in an electronic device having a transmission line using a rigid/flexible printed circuit board (RF PCB).

According to an embodiment of the disclosure, since the influence of electrical or mechanical components having metal components such as a hinge battery in an electronic device is relatively less compared to CPW, the impedance change rate due to metal proximity may be enhanced.

The technical objects of the disclosure are not limited to the foregoing, and other technical objects may be derived by one of ordinary skill in the art from example embodiments of the disclosure.

Effects of the present invention are not limited to the foregoing, and other unmentioned effects would be apparent to one of ordinary skill in the art from the following description. In other unintended in practicing of the words, effects embodiments disclosure may also be derived by one of ordinary skill in the art from example embodiments of the disclosure.

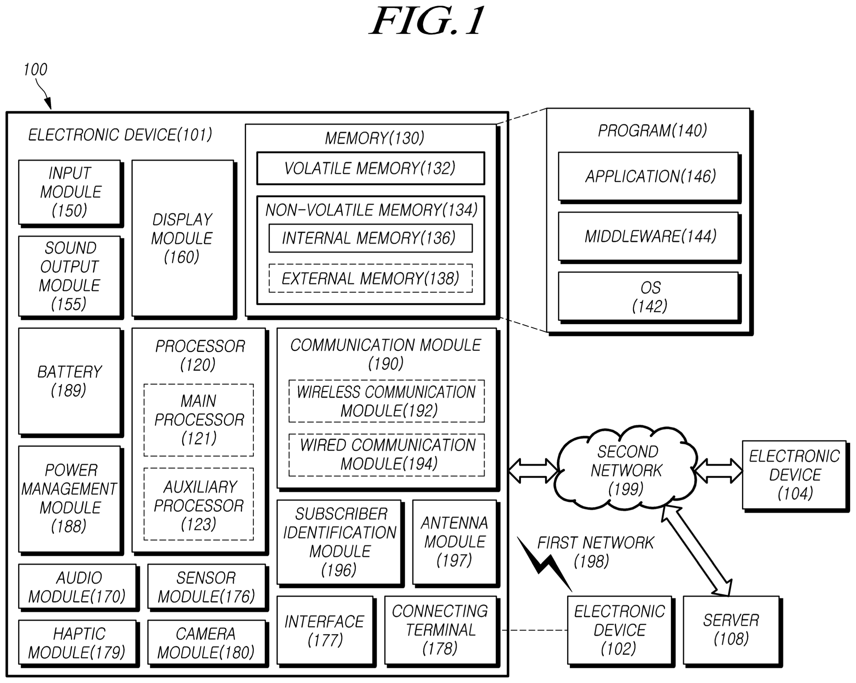

FIG. 1 is a block diagram illustrating an electronic device 101 in a network environment 100 according to various embodiments;

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., the program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134. For example, the non-volatile memory 134 may include an internal memory 136 and/or an external memory 138.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operation state (e.g., power or temperature) of the electronic device 101 or an external environmental state (e.g., the user's state), and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth™, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include an antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

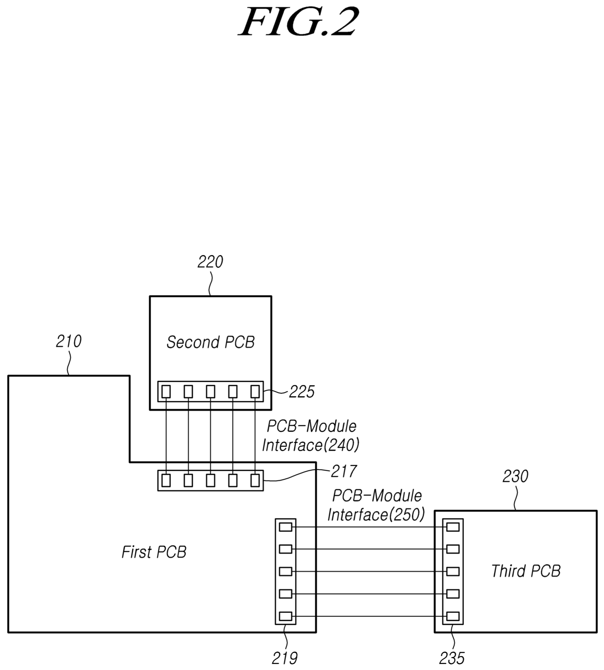

FIG. 2 is a view illustrating an application example of a rigid/flexible printed circuit board (RF PCB) in an electronic device (e.g., the electronic device 101 of FIG. 1) according to an embodiment of the disclosure.

Referring to FIG. 2, an electronic device 101 may include a plurality of PCBs 210, 220, 230, 240, 250. Each of the plurality of PCBs 210, 220, 230, 240, 250 may be one of a rigid PCB (RPCB) or a flexible PCB (FPCB).

As an example, a first PCB 210, a second PCB 220, or a third PCB 230 may be a rigid PCB. The rigid PCB may be a PCB without flexibility. As an example, a fourth PCB 240 or a fifth PCB 250 may be a flexible PCB. The flexible PCB may be a PCB having flexibility. The fourth PCB 240 or the fifth PCB 250 having flexibility may serve as a PCB-module interface connecting between the first PCB 210, the second PCB 220, or the third PCB 230 corresponding to rigid PCBs. The fourth PCB 240 or the fifth PCB 250 serving as the connecting PCB-module interface may include electrical lines including at least one signal line or at least one ground line. The fourth PCB 240 or the fifth PCB 250 may be made with electrical lines surrounded by a dielectric.

The fourth PCB 240 may serve as a first PCB-module interface connecting between the first PCB 210 and the second PCB 220. The structure in which the first PCB 210 and the second PCB 220 are connected by the fourth PCB 240 may be referred to as one rigid/flexible printed circuit board (RF PCB). In this case, the first PCB 210 and the second PCB 220 may be disposed within the electronic device 101 at a predetermined angle rather than in a plane by the fourth PCB 240.

The fifth PCB 250 may serve as a second PCB-module interface connecting between the first PCB 210 and the third PCB 230. The structure in which the first PCB 210 and the third PCB 230 are connected by the fifth PCB 250 may be referred to as one rigid/flexible printed circuit board (RF PCB). In this case, the first PCB 210 and the third PCB 230 may be disposed within the electronic device 101 at a predetermined angle rather than in a plane by the fifth PCB 250.

The first PCB 210 may include electrical contact points 217 for electrically connecting the fourth PCB 240 serving as the first PCB-module interface. The first PCB 210 may include electrical contact points 219 for electrically connecting the fifth PCB 250 serving as the second PCB-module interface.

The second PCB 220 may include electrical contact points 225 for electrically connecting the fourth PCB 240 serving as the first PCB-module interface. The third PCB 230 may include electrical contact points 235 for electrically connecting the fifth PCB 250 serving as the second PCB-module interface.

According to an example, for signal exchange and/or other power supply, the first PCB 210 may be connected to another PCB (e.g., the second PCB 220 or the third PCB 230) by a flexible PCB (e.g., the fourth PCB 240 or the fifth PCB 250) such as a flexible printed circuit board (FPCB), flexible RF cable (FRC), or interposer. The FRC may be defined as a cable that has flexibility so as not to break even when folded and bent, and has impedance matching for transmitting electrical signals.

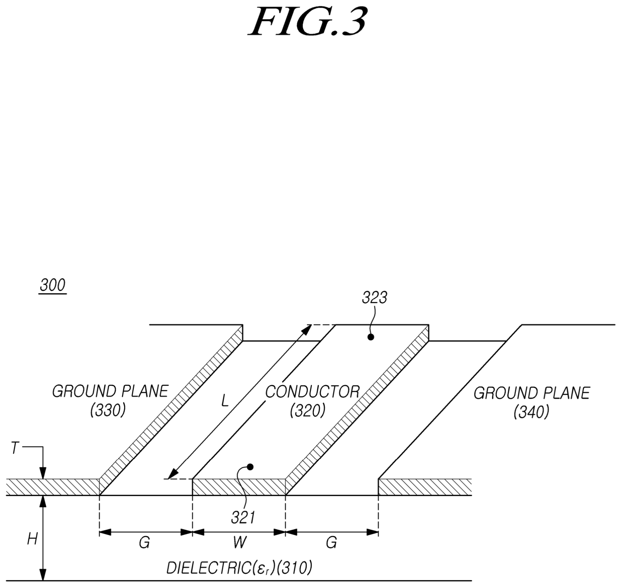

FIG. 3 is a view illustrating a coplanar waveguide (CPW) structure that may be applied to a conductor layer of a printed circuit board (PCB) in an electronic device (e.g., the electronic device 101 of FIG. 1) according to an embodiment of the disclosure.

Referring to FIG. 3, a PCB used in an electronic device 101 may include a rigid PCB (RPCB), a flexible PCB (FPCB), or a rigid/flexible PCB (RF PCB).

The rigid PCB may be a hard PCB that does not have bending characteristics due to flexibility. The rigid PCB may be used, e.g., for mounting electronic components or elements by soldering. The rigid PCB may have a multilayer structure in which a plurality of conductor layers are separated by dielectric layers and stacked. The conductor layer may be a layer on which electrical line for the flow of electrical signals may be provided. The dielectric layer may be a layer formed of non-conductive material surrounding the conductor layer. The conductor layer may be stacked with the dielectric layer therebetween. Such a structure in which a plurality of conductor layers are stacked is called a 'multilayer structure'.

The flexible PCB may be a soft PCB having bending characteristics due to flexibility. The flexible PCB may be used, e.g., as a cable for electrically connecting between rigid PCBs or between electronic components or elements. The flexible PCB may have a structure that wraps one or more conductor layers using a dielectric.

The rigid/flexible PCB is a structure in which a flexible PCB and a rigid PCB are combined, and may be an integrated PCB that may provide both flexibility by the flexible PCB and reliability of surface mounting by the rigid PCB. For example, the rigid/flexible PCB may be used in electronic devices such as smartphones or camera modules that need to be thin and flexible.

The conductor layer of the rigid PCB, the flexible PCB, or the rigid/flexible PCB may include CPW. The CPW may be a transmission line in which signal line and ground line are implemented on one surface of a dielectric substrate. In the following description, 'CPW structure' will be used to refer to a structure in which transmission lines (e.g., signal line or ground line) are disposed on one surface of a dielectric substrate.

According to an example, a CPW structure 300 may have a structure that may reduce transmission loss by forming a conductor layer including transmission lines on one surface (e.g., upper surface or lower surface) of a dielectric layer 310. The conductor layer in the CPW structure 300 may include electrical line according to a predetermined metal pattern. The electrical line in the CPW structure 300 may include, e.g., one or more signal lines (SIGNAL) 320 or one or more ground lines (GND) 330, 340. For example, the one or plurality of signal lines 320 may be provided with at least one electrical contact point 321, 323 for electrical connection to electronic components or elements near two opposite ends. One of the first and second electrical contact points 321, 323 provided near two opposite ends of the one or plurality of signal lines 320 may be an input terminal for receiving an electrical signal from an electrically connected electronic component or element. One of the first and second electrical contact points 321, 323 provided near two opposite ends of the one or plurality of signal lines 320 may be an output terminal for transmitting an electrical signal to an electrically connected electronic component or element. The one or plurality of signal lines 320 may enable bi-directional transmission of electrical signals between the first and second electrical contact points 321, 323.

As an example, one or more signal lines 320 or one or more ground lines 330, 340 corresponding to electrical line in the CPW structure 300 may be disposed to be spaced apart by a predetermined clearance G on one surface (e.g., upper surface) which is a two-dimensional plane of the dielectric layer 310. For example, the signal line 320 may be disposed parallel between a first ground line 330 and a second ground line 340 on the dielectric layer 310. The dielectric layer 310 may have a predetermined thickness H. The dielectric layer 310 may have a predetermined permittivity $\varepsilon_r$.

The CPW structure 300 is an electrical line in which ground lines 330, 340 disposed at a predetermined clearance G apart in a plane parallel to the signal line 320 exist, and may be used for monolithic microwave integrated circuit (MMIC) or microwave integrated circuit (MIC). The CPW structure 300 may enable mounting of elements in the same layer because the signal line 320 and ground lines 330, 340 are present in one layer which is a two-dimensional plane.

According to an example, a capacitance C or inductance L formed between the signal line 320 and ground lines 330, 340 in the CPW structure 300 may determine the characteristic impedance $Z_0$ in the CPW structure 300. The characteristic impedance $Z_0$ may be defined as in Equation 1 below.

[Equation 1]

$$Z_0 \propto \sqrt{\frac{L}{C}}$$

The characteristic impedance $Z_0$ in the CPW structure 300 may be determined by the capacitance C or inductance L. According to Equation 1 above, it may be identified that the characteristic impedance $Z_0$ is inversely proportional to the capacitance C. For example, the characteristic impedance $Z_0$ may increase as the capacitance C decreases, and may decrease as the capacitance C increases.

The capacitance C between the signal line 320 and ground lines 330, 340 in the CPW structure 300 may be affected by the length L, width W, or thickness T of the signal line 320 and/or ground lines 330, 340. The signal line 320 or ground lines 330, 340 in the CPW structure 300 may use, e.g., copper with a thickness of about 12 micrometers ($\mu$m). As an example, the capacitance C between the signal line 320 and ground lines 330, 340 in the CPW structure 300 may be affected by the clearance G between the signal line 320 and ground lines 330, 340.

As an example, an FPCB may have limitations in widening the width W or increasing the thickness T of the signal line 320 and/or ground lines 330, 340 to ensure flexibility. Further, an FPCB may have limitations in extending the length L due to lack of installation space inside the electronic device 101. For this reason, in the CPW structure 300, the characteristic impedance $Z_0$ may be adjusted by adjusting the clearance G between the signal line 320 and ground lines 330, 340.

As an example, since the characteristic impedance of components included in an electronic device is designed to be 50 ohms, it is necessary to match the characteristic impedance in electrical line using rigid/flex PCB such as FRC that electrically connects the components to about 50 ohms. In case that the characteristic impedance in the line deviates from about 50 ohms, return loss and/or insertion loss may increase. For this reason, to match the characteristic impedance to about 50 ohms in the CPW structure 300, the clearance G between the signal line 320 and ground lines 330, 340 should be designed to be narrowed to 50 micrometers ($\mu$m) or less. However, due to limitations of the manufacturing process, in case that the clearance G between the signal line 320 and ground lines 330, 340 is narrowed to 50 micrometers ($\mu$m) or less, the possibility of a short occurring between the signal line 320 and ground lines 330, 340 may increase. As an example, the clearance G between the signal line 320 and ground lines 330, 340 may be manufactured to be about 50 to 60 micrometers ($\mu$m), in which case the characteristic impedance may have a value between about 60 to 70 ohms.

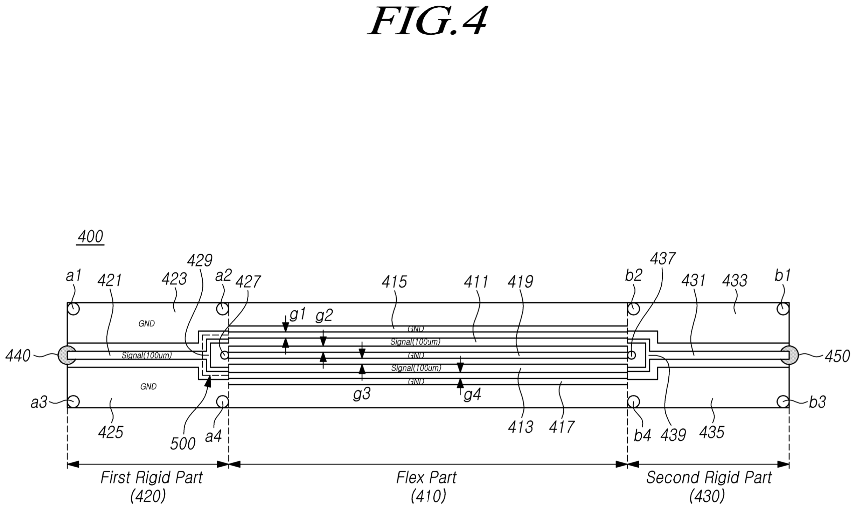

FIG. 4 is a structural diagram illustrating a coplanar waveguide (CPW) applied to a rigid/flexible printed circuit board (RF PCB) 400 in an electronic device (e.g., the electronic device 101 of FIG. 1) according to an embodiment of the disclosure.

Referring to FIG. 4, a CPW structure (e.g., the CPW structure 300 of FIG. 3) may reduce transmission loss by forming a conductor layer having a predetermined metal pattern corresponding to a transmission line on one surface (e.g., top and/or lower surface) of a dielectric layer.

According to an example, a rigid/flexible printed circuit board (RF PCB) 400 in an electronic device 101 may include a flex part 410 corresponding to a flexible PCB or a first rigid part 420 and/or a second rigid part 430 corresponding to a rigid PCB. The flex part 410 may be disposed between the first rigid part 420 and the second rigid part 430. For example, the first rigid part 420 and the second rigid part 430 may be disposed on two opposite sides with the flex part 410 therebetween. The first rigid part 420 may be electrically connected to one side of the flex part 410, for example. The second rigid part 430 may be electrically connected to the other side of the flex part 410, for example. Although the drawing illustrates a structure in which two rigid parts 420, 430 are connected on two opposite sides of one flex part 410, the examples to be described below may be applied identically or similarly to a rigid/flexible printed circuit board (RF PCB) 400 including a plurality of flex parts.

The flex part 410 may be guaranteed to have bending characteristics with some degree of flexibility. The bending characteristic may be, e.g., a characteristic that it may be bent by external force. For this purpose, it may have a structure in which a conductor layer provided with electrical line corresponding to a transmission line is wrapped using a dielectric. Therefore, the flex part 410, which is a section without adhesive, may have bending characteristics that provide flexibility.

The bending characteristics in the first and second rigid parts 420, 430 may not be guaranteed to have flexibility. As an example, the first and second rigid parts 420, 430 may have a structure in which conductor layers are stacked with a dielectric layer therebetween. As an example, the first and second rigid parts 420, 430 may not have flexibility due to the manufacturing method of the dielectric and conductor. As an example, the flexibility of the first and second rigid parts 420, 430 may also be affected by adhesive (e.g., PPG, bonding sheet) used for stacking the dielectric layer and conductor layer.

The conductor layer of the rigid/flexible printed circuit board (RF PCB) 400 may have a CPW structure 300 in which the conductor layer of the flex part 410 is electrically connected to the conductor layer of the first rigid part 420 and/or the conductor layer of the second rigid part 430 by signal line and/or ground line. The CPW structure 300 may, e.g., extend from a signal line 421 (hereinafter referred to as 'first rigid signal line') of the first rigid part 420 in a coplanar manner, branching into at least two signal lines to signal lines 411, 413 (hereinafter referred to as 'flex signal lines') existing in the flex part 410. The CPW structure 300 may, e.g., extend from a signal line 431 (hereinafter referred to as 'second rigid signal line') of the second rigid part 430 in a coplanar manner, branching into at least two signal lines to the flex signal lines 411, 413 existing in the flex part 410.

According to an example, the CPW structure 300 applied to the conductor layer of the rigid/flexible printed circuit board (RF PCB) 400 may be configured with different electrical line for the flex part 410 and the rigid part (e.g., the first rigid part 420 or the second rigid part 430). As an example, the conductor layer of the rigid/flexible printed circuit board (RF PCB) 400 may be designed with a CPW structure 300 to include one rigid signal line 421, 431 in the first rigid part 420 and/or the second rigid part 430, and to include a plurality of flex signal lines 411, 413 in the flex part 410. The one first rigid signal line 421 provided in the first rigid part 420 may be divided into a plurality of signal lines and electrically connected to the plurality of flex signal lines 411, 413 provided in the flex part 410. The one second rigid signal line 431 provided in the second rigid part 430 may be divided into a plurality of signal lines and electrically connected to the plurality of flex signal lines 411, 413 provided in the flex part 410.

In the first rigid part 420, ground planes 423, 425 (hereinafter referred to as 'first rigid ground planes') may be disposed at a predetermined distance apart on two opposite sides of one first rigid signal line 421. In the second rigid part 430, ground planes 433, 435 (hereinafter referred to as 'second rigid ground planes') may be disposed at a predetermined distance apart on two opposite sides of one second rigid signal line 431.

According to an example, in the flex part 410, each of the plurality of flex signal lines 411, 413 may be disposed at predetermined clearances g1, g2, g3, g4 apart between ground lines 415, 417, 419 (hereinafter referred to as 'flex ground lines'). The flex part 410 may be provided with, e.g., at least one inner flex ground line 419 or a plurality of outer flex ground lines 415, 417. In an embodiment, the flex signal lines 411, 413 may be disposed parallel on two opposite sides of the inner flex ground line 419 at a predetermined spacing g2, g3 apart in a two-dimensional plane. The outer flex ground lines 415, 417 may be disposed parallel with flex signal lines 411, 413 on one side at a predetermined spacing g1, g4 apart in a two-dimensional plane.

According to an example, in the CPW structure 300, the first rigid part 420 may be provided with via holes a1, a2, a3, a4 for electrical connection to other conductor layers by penetrating the dielectric layer near the substantial edge. However, the via holes a1, a2, a3, a4 in the first rigid part 420 may be provided at positions other than near the edge.

According to an example, the first rigid part 420 may be provided with a first terminal 440 near one end. The first terminal 440 may be, e.g., an electrical contact point for electrically connecting electrical components or elements. In an embodiment, in the first rigid part 420, the first rigid signal line 421 extending from the first terminal 440 may branch into two or more signal lines at a first junction 429. In the first rigid signal line 421 or the branched two or more signal lines, bi-directional signal transmission may be possible to transmit electrical signals input through the first terminal 440 toward the other end (e.g., the flex part 410), or to output electrical signals transmitted from the other end to the first terminal 440. The width (e.g., about 50 micrometers ($\mu$m)) of the branched signal lines may be narrower than the width (e.g., about 100 micrometers ($\mu$m)) of the first rigid signal line 421 before branching. As an example, in case that the first rigid signal line 421 extending from the first terminal 440 branches into two signal lines at the first junction 429, the width of each of the branched two signal lines may be substantially half (1/2) of the width of the first rigid signal line 421 before branching.

According to an example, the first rigid part 420 may include a first via hole 427 in a coplanar surface between the two or more signal lines branched at the first junction 429. The first via hole 427 may be ground-connected to at least one other conductor layer stacked in an upward direction and/or downward direction of the corresponding conductor layer by penetrating the dielectric layer. Although the drawing illustrates an example in which one first via hole 427 is provided in the first rigid part 420, more via holes may be provided.

The first rigid part 420 may include first rigid ground planes 423, 425 provided on two opposite sides with the first rigid signal line 421 and the branched signal lines therebetween in a coplanar manner. The first rigid ground planes 423, 425 may be ground-connected to other conductor layers by via holes a1, a2, a3, a4. The first rigid ground planes 423, 425 may be spaced at a predetermined distance to be insulated from the first rigid signal line 421 or the branched signal lines.

According to an example, in the CPW structure 300, the second rigid part 430 may be provided with via holes b1, b2, b3, b4 for electrical connection to other conductor layers by penetrating the dielectric layer near the substantial edge. However, the via holes b1, b2, b3, b4 in the second rigid part 430 may be provided at positions other than near the edge.

According to an example, a second terminal 450 may be provided near one end of the second rigid part 430. The second terminal 450 may be, e.g., an electrical contact point for electrically connecting electrical components or elements. In an embodiment, in the second rigid part 430, the second rigid signal line 431 extending from the second terminal 450 may branch into two or more signal lines at a second junction 439. In the second rigid signal line 431 or the branched two or more signal lines, bi-directional signal transmission may be possible to transmit electrical signals input through the second terminal 450 toward the other end (e.g., the flex part 410), or to output electrical signals transmitted from the other end to the second terminal 450. The width (e.g., about 50 micrometers ($\mu$m)) of the branched signal lines may be narrower than the width (e.g., about 100 micrometers ($\mu$m)) of the second rigid signal line 431 before branching. As an example, in case that the second rigid signal line 431 extending from the second terminal 450 branches into two signal lines at the second junction 439, the width of each of the branched two signal lines may be substantially half (1/2) of the width of the second rigid signal line 431 before branching.

According to an example, the second rigid part 430 may include a second via hole 437 in a coplanar surface between the two or more signal lines branched at the second junction 439. The second via hole 437 may be ground-connected to at least one other conductor layer stacked in an upward direction and/or downward direction of the corresponding conductor layer by penetrating the dielectric layer. Although the drawing illustrates an example in which one second via hole 437 is provided in the second rigid part 430, more via holes may be provided.

The second rigid part 430 may include second rigid ground planes 433, 435 provided on two opposite sides with the second rigid signal line 431 and the branched signal lines therebetween in a coplanar manner. The second rigid ground planes 433, 435 may be ground-connected to other conductor layers by via holes b1, b2, b3, b4. The second rigid ground planes 433, 435 may be spaced at a predetermined distance to be insulated from the second signal line 431 or the branched signal lines.

According to an example, in the CPW structure 300, the flex part 410 may include a plurality of electrical lines disposed parallel at predetermined clearances g1, g2, g3, g4 apart in a coplanar manner. The predetermined clearances g1, g2, g3, g4 may be designed to be, e.g., about 50 micrometers ($\mu$m) or more. The electrical line may be an electrical line that allows electrical signals to be transmitted using a conductor (e.g., copper). As an example, the plurality of electrical lines provided in the flex part 410 may include a plurality of flex signal lines 411, 413 or a plurality of flex ground lines 415, 417, 419. The plurality of flex signal lines 411, 413 and the plurality of flex ground lines 415, 417, 419 may be alternately disposed in a coplanar manner. The plurality of flex signal lines 411, 413 may have substantially the same width W (e.g., about 100 micrometers ($\mu$m)) as the rigid signal lines 421, 431 before branching included in the first or second rigid parts 420, 430. In an embodiment, widths of the plurality of flex ground lines 415, 417, 419 may be less than widths of the plurality of flex signal lines 411, 413.

As an example, one flex ground line 419 (hereinafter referred to as 'inner flex ground line') may be disposed at a substantially middle position in a coplanar surface (e.g., the upper surface of the dielectric layer) corresponding to the flex part 410. The inner flex ground line 419 may be provided between two flex signal lines 411, 413. As an example, two flex ground lines 415, 417 (hereinafter referred to as 'outer flex ground lines') may be disposed at substantially the outermost positions in a coplanar surface (e.g., the upper surface of the dielectric layer) corresponding to the flex part 410. As an example, a first flex signal line 411, which is one of the two flex signal lines 411, 413, may be disposed at predetermined clearances g1, g2 apart between a first outer flex ground line 415, which is one of the two outer flex ground lines 415, 417, and the inner flex ground line 419. As an example, a second flex signal line 413, which is the other one of the two signal lines 411, 413, may be disposed at predetermined clearances g3, g4 apart between a second outer flex ground line 417, which is the other one of the two outer flex ground lines 415, 417, and the inner flex ground line 419.

The characteristic impedance $Z_0$ in the CPW structure 300 where the plurality of flex signal lines 411, 413 and the plurality of flex ground lines 415, 417, 419 are disposed in a coplanar manner as described above may be defined by Equation 2 below.

[Equation 2]

$$Z_0 = Z_1 + Z_2 \propto \sqrt{\frac{L_1}{C_1}} + \sqrt{\frac{L_2}{C_2}}$$

Here, $Z_1$ is the characteristic impedance in the first flex signal line 411 disposed in the flex part 410, $L_1$ and $C_1$ are the capacitance and inductance in the first flex signal line 411 disposed in the flex part 410, $Z_2$ is the characteristic impedance in the second flex signal line 413 disposed in the flex part 410, and $L_2$ and $C_2$ are the capacitance and inductance in the second flex signal line 413 disposed in the flex part 410.

According to Equation 2 above, the characteristic impedance in the flex part 410 forming the transmission line may obtain substantially twice the capacitor capacity compared to the CPW structure 300 with one signal line and two ground lines, due to the capacitances formed between the two flex signal lines 411, 413 and the three flex ground lines 415, 417, 419. This may enable impedance matching with internal electronic components or elements without excessively narrowing the spacing G between the signal line and ground line. For example, a characteristic impedance of 50 ohms may be obtained on the transmission line without narrowing the spacing G between the signal line and ground line to 50 micrometers ($\mu$m) or less.

According to an example, in the CPW structure 300, the inner flex ground line 419 disposed in the flex part 410 may have one end ground-connected to another layer (e.g., a conductor layer stacked in an upward or downward direction) through the first via hole 427 provided in the first rigid part 420, and the other end ground-connected to another layer (e.g., a conductor layer stacked in an upward or downward direction) through the second via hole 437 provided in the second rigid part 430.

According to an example, in the CPW structure 300, the first outer flex ground line 415 disposed in the flex part 410 may have one end extending to and connected to the first rigid ground plane 423 provided in the first rigid part 420, and the other end extending to and connected to the second rigid ground plane 433 provided in the second rigid part 430.

According to an example, in the CPW structure 300, the second outer flex ground line 417 disposed in the flex part 410 may have one end extending to and connected to the first rigid ground plane 425 provided in the first rigid part 420, and the other end extending to and connected to the second rigid ground plane 435 provided in the second rigid part 430.

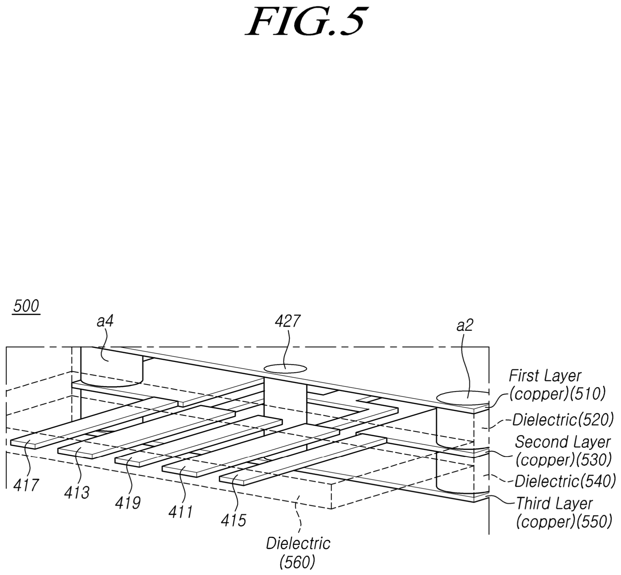

FIG. 5 is a structural diagram illustrating a part (e.g., reference number 500 of FIG. 4) where line of a rigid part (e.g., the first rigid part 420 or the second rigid part 430 of FIG. 4) and line of a flex part (e.g., the flex part 410 of FIG. 4) are connected in a transmission line of an electronic device (the electronic device 101 of FIG. 1) according to an embodiment of the disclosure.

Referring to FIG. 5, a rigid/flexible printed circuit board (RF PCB) (e.g., the rigid/flexible printed circuit board (RF PCB) 400 of FIG. 4) may have a structure in which a rigid PCB (e.g., the first rigid part 420 or the second rigid part 430 of FIG. 4) and a flexible PCB (e.g., the flex part 410 of FIG. 4) are electrically connected. Although the drawing illustrates a part where one rigid PCB (e.g., the first rigid part 420 of FIG. 4) and one flexible PCB 410 are connected, the other end of the flexible PCB 410 may be electrically connected to another rigid PCB (e.g., the second rigid part 430 of FIG. 4). In this case, the two rigid PCBs (e.g., the first rigid part 420 and the second rigid part 430 of FIG. 4) electrically coupled to two opposite sides of the flexible PCB 410 may have the same or similar structure.

According to an example, the rigid PCB 420 may have a multilayer structure. The multilayer structure may be a structure in which a plurality of conductor layers 510, 530, 550 are stacked with dielectric layers 520, 540 therebetween.

Although the drawing illustrates an example in which three conductor layers 510, 530, 550 are stacked with two dielectric layers 520, 540 therebetween, more (e.g., 4 or more) conductor layers or dielectric layers may be stacked. For example, the three conductor layers 510, 530, 550 in the rigid PCB 420 may be bonded using an adhesive (e.g., PPG, bonding sheet). Accordingly, it may be difficult to guarantee bending characteristics with flexibility in the rigid PCB 420. The plurality of conductor layers 510, 530, 550 included in the rigid PCB 420 may have electrical connections through one or more via holes a2, a4 penetrating the dielectric layers 520, 540. As an example, a ground plane provided in the first conductor layer 510 corresponding to layer 1 of the multilayer may be electrically connected to a ground line (e.g., the first rigid ground plane 425 of FIG. 4) provided in the second conductor layer 530 corresponding to layer 2 of the multilayer through via holes a2, a4 penetrating the first dielectric layer 520. As an example, a ground line provided in the second conductor layer 530 corresponding to layer 2 of the multilayer may be electrically connected to a ground plane provided in the third conductor layer 550 corresponding to layer 3 of the multilayer through via holes a2, a4 penetrating the second dielectric layer 540. Thus, in the multilayer structure, the second conductor layer 530 positioned in the middle layer may be ground-connected to conductor layers 510, 550 disposed in other layers (e.g., the first conductor layer 510 stacked in an upward direction or the third conductor layer 550 stacked in a downward direction) through a plurality of via holes (e.g., a1 to a4 or b1 to b4 of FIG. 4).

As an example, the top (layer 1) and bottom (layer 3) conductor layers 510, 550 included in the rigid PCB 420 may have a via hole (e.g., the first via hole 427 or the second via hole 437 of FIG. 4) formed to pass through a coplanar surface where the signal line 421, 431 branches into two signal lines in the middle conductor layer 530 by penetrating the dielectric layers 520, 540. The via hole 427 may be disposed, e.g., to pass through a position adjacent to the flexible PCB in the coplanar surface where the signal line 421, 431 branches into two signal lines. The via hole 427 may have one end electrically connected to the ground plane of the first conductor layer 510 disposed at the top, and the other end electrically connected to the ground plane of the third conductor layer 550 disposed at the bottom.

According to an example, the conductor layer 530 disposed in the middle of the rigid PCB 420 having a stacked structure in the rigid/flexible printed circuit board (RF PCB) 400 may include a signal line (e.g., the first rigid signal line 421 or the second rigid signal line 431 of FIG. 4) or a plurality of ground lines (e.g., the first rigid ground planes 423, 425 or the second rigid ground planes 433, 435 of FIG. 4). The signal line 421, 431 in the middle (layer 2) conductor layer 530 of the rigid PCB 420 may branch into two signal lines at a junction (e.g., the first junction 429 or the second junction 439 of FIG. 4). Each of the branched two signal lines may be electrically connected to signal line (e.g., the first and second flex signal lines 411, 413 of FIG. 4) provided in the flexible PCB 410. A ground line starting from the via hole 427 provided to penetrate the coplanar surface after branching into the two signal lines may be electrically connected to the inner flex ground line 419 (e.g., the inner flex ground line 419 of FIG. 4) provided in the flexible PCB 410. The ground planes 423, 435 or 433, 435 in the middle conductor layer 530 of the rigid PCB 420 may extend to the ground lines 415, 417 (e.g., the first and second outer flex ground lines 415, 417 of FIG. 4) provided in the flexible PCB 410.

As an example, one conductor layer in the flexible PCB 410 may be wrapped by a dielectric 560 and may have bending characteristics with flexibility.

The structure in which the rigid PCB 420 and the flexible PCB 410 described above are electrically connected may extend in a horizontal direction ($\pm$y-axis direction) in the rigid/flexible printed circuit board (RF PCB) 400. For example, the rigid/flexible printed circuit board (RF PCB) 400 may include an electrical connection structure of several rigid PCBs and flexible PCBs provided in the transverse axis ($\pm$z-axis direction).

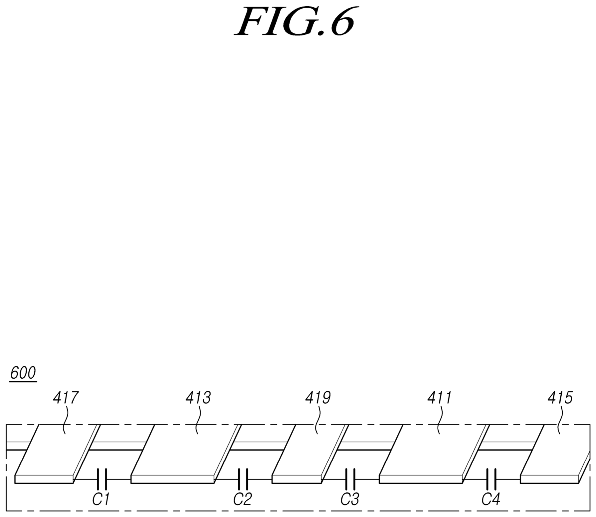

FIG. 6 is a view illustrating an example of capacitance formation between transmission lines provided in a flex part in an electronic device (e.g., the electronic device 101 of FIG. 1) according to an embodiment of the disclosure.

Referring to FIG. 6, the transmission line of the CPW structure (e.g., the CPW structure 300 of FIG. 3) in the electronic device 101 may have a plurality of signal lines (e.g., the first and second flex signal lines 411, 413 of FIG. 4) or a plurality of flex ground lines (e.g., 415, 417, 419 of FIG. 4) disposed side by side in a horizontal plane. For example, the plurality of signal lines 411, 413 may be disposed while maintaining a predetermined spacing between the plurality of ground lines 415, 417, 419. Accordingly, a predetermined capacitance may be formed between the signal lines 411, 413 and the ground lines 415, 417, 419. As an example, the first signal line 411 may have a capacitance C4 formed between it and the first outer ground line 415, and a capacitance C3 formed between it and the inner ground line 419. As an example, the second signal line 413 may have a capacitance C1 formed between it and the second outer ground line 417, and a capacitance C2 formed between it and the inner ground line 419. The capacitances C1 to C4 may determine the characteristic impedance of the transmission line.

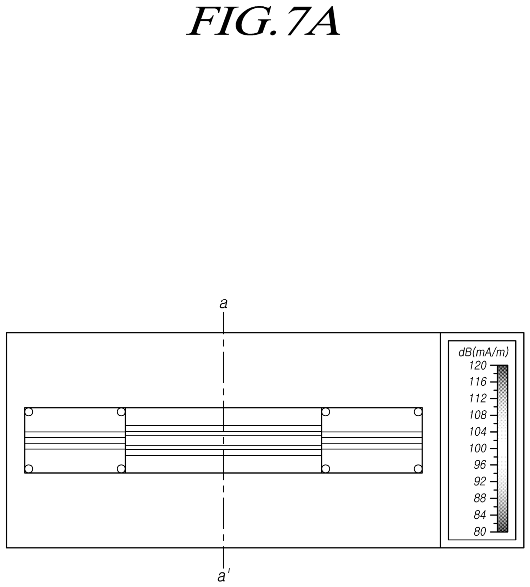

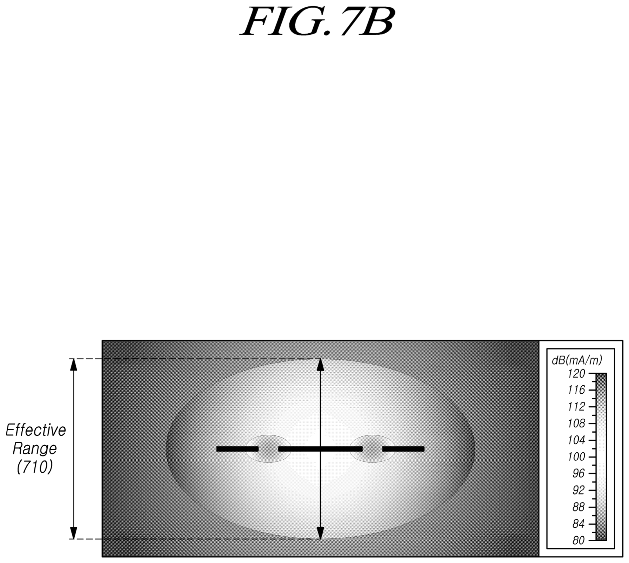

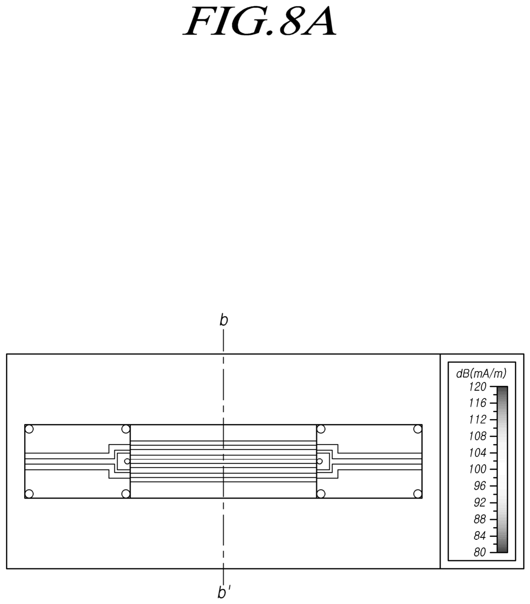

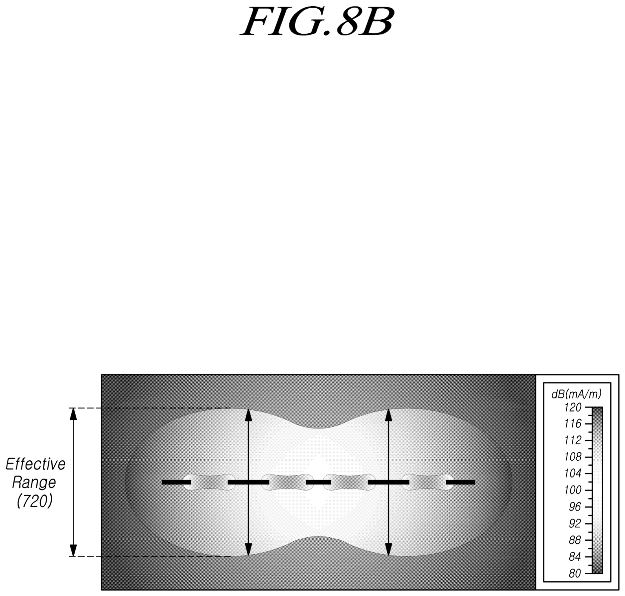

FIG. 7A or FIG. 7B is a view illustrating an example of surface current flowing in line in a general CPW structure, and FIG. 8A or FIG. 8B is a view illustrating an example of surface current flowing in line in a CPW structure (e.g., the CPW structure 300 of FIG. 3) according to an embodiment of the disclosure.

Referring to FIGS. 7A, 7B, 8A, or 8B, the surface current in a cross-section cut along the b-b' line of the CPW structure 300 where the signal line is branched may be decreased by about 6 dB for each line compared to the surface current in a cross-section cut along the a-a' line of the CPW structure 300 according to a related example in which the signal line is not branched. Accordingly, the effective field areas 710, 720 may be decreased in the $\pm$Z axis, thereby reducing the influence (e.g., interference) from surrounding metal objects. For example, the CPW structure 300 according to an embodiment of the disclosure may reduce the impedance change rate due to metal proximity because it is relatively less affected by electrical or mechanical components having metal components such as a hinge battery in an electronic product (e.g., the electronic device 101 of FIG. 1) compared to the CPW according to the related example.

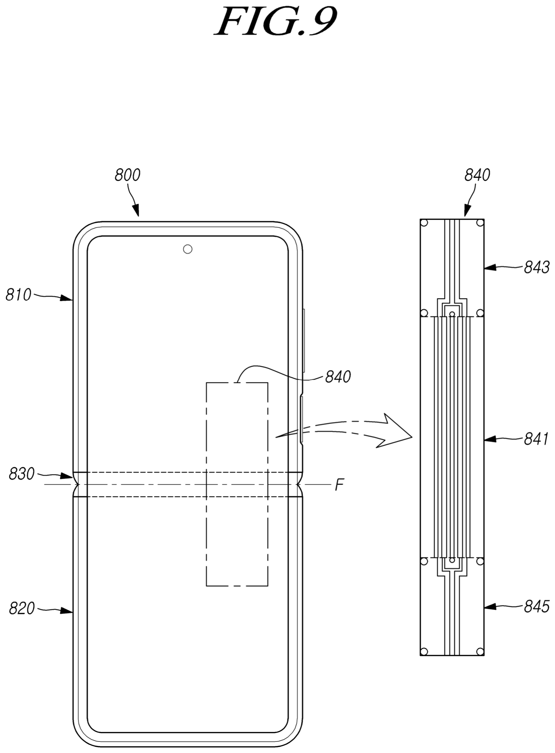

FIG. 9 is an example view where a rigid/flexible printed circuit board (RF PCB) (e.g., the rigid/flexible printed circuit board (RF PCB) 400 of FIG. 4) is applied to an electronic device (e.g., the electronic device 101 of FIG. 1) according to an embodiment of the disclosure.

Referring to FIG. 9, a rigid/flexible printed circuit board (RF PCB) 840 may be disposed considering a part 830 that may be bent, curved, folded, or rolled in an electronic device 800 such as a foldable model or rollable model. The rigid/flexible printed circuit board (RF PCB) 840 may have, e.g., a structure in which rigid parts 843, 845 (e.g., the first rigid part 420 or the second rigid part 430 of FIG. 4) are electrically coupled on two opposite sides of a flex part 841 (e.g., the flex part 410 of FIG. 4).

According to an example, an electronic device 800 with a foldable structure may include a first folder part 810 or a second folder part 820 without flexibility. The first folder part 810 may correspond to a front folder. The second folder part 820 may correspond to a rear folder. The electronic device 800 with the foldable structure may include a folding part 830 provided between the first folder part 810 and the second folder part 820 so that the first folder part 810 and the second folder part 820 may be folded at a predetermined angle. The folding part 830 may have a hinge structure in which the first folder part 810 and the second folder part 820 may be rotatably coupled based on a rotation axis F.

According to an example, the first rigid part 843 included in the rigid/flexible printed circuit board (RF PCB) 840 may be disposed in the first folder part 810. The second rigid part 845 included in the rigid/flexible printed circuit board (RF PCB) 840 may be disposed in the second folder part 820. The flex part 841 included in the rigid/flexible printed circuit board (RF PCB) 840 may be disposed in the folding part 830. As the flex part 841 has flexibility, it may not create any particular resistance to folding in the folding part 830.

Although an example applied to a foldable model has been described above, it would be possible to dispose the flex part 841 included in the rigid/flexible printed circuit board (RF PCB) 840 at a position where flexibility is needed for electronic devices having a structure that may be bent, curved, folded, or rolled besides the foldable model.

According to an example, an electronic device 101 may include a printed circuit board 400 including at least one conductor layer configured such that a first rigid part 420 and a second rigid part 430 are disposed on two opposite sides with a flex part 410 therebetween.

As an example, an electrical line may be configured in the at least one conductor layer to enable signal transmission between a first electrical contact point 440 provided in the first rigid part 420 for electrical connection to a first external element and a second electrical contact point 450 provided in the second rigid part 430 for electrical connection to a second external element.

As an example, the electrical line may be configured such that a first signal line starting from the first electrical contact point branches into at least two at a first junction and extends to second signal lines of the flex part, and one end of a first ground line disposed between the second signal lines is ground-connected to another conductor layer through a first via hole penetrating a dielectric in the first rigid part.

As an example, the electrical line may be configured such that the second signal lines 411, 413 merge into a third signal line 431 at a second junction 439 extending to the second electrical contact point 450, and the other end of the first ground line 419 is ground-connected to another conductor layer through a second via hole 437 penetrating a dielectric in the second rigid part 430.

As an example, the first junction 429 may be included in the first rigid part 420, and the second junction 439 may be included in the second rigid part 430.

As an example, the electrical line may be configured such that one side of a second ground line 415, 417 disposed parallel to the first ground line 419 with one of the second signal lines 411, 413 therebetween in the flex part 410 extends to a ground plane 423, 425 of the first rigid part 420, and the other side of the second ground line 415, 417 extends to a ground plane 433, 435 of the second rigid part 430.

As an example, the electrical line may be configured such that in the flex part 410, the first ground line 419 is spaced apart from each of the second signal lines 411, 413 by a first clearance g2, g3, and the second ground line 415, 417 is disposed parallel to and spaced apart from the second signal line 411, 413 disposed between it and the first ground line 419 by a second clearance g1, g4.

As an example, the first clearance g2, g3 or the second clearance g1, g4 may be designed to be greater than 50 micrometers ($\mu$m) so that the characteristic impedance of the electrical line may satisfy a preset value for impedance matching with the first external element or the second external element.

As an example, the preset value considering impedance matching with the first external element or the second external element may be 50 ohms.

As an example, the electrical line may be configured such that in the flex part 410, second ground lines 415, 417 are disposed parallel to the first ground line 419 with each of the second signal lines 411, 413 therebetween, one side of the second ground lines 415, 417 extends to ground planes 423, 425 of the first rigid part 420, and the other side of the second ground lines 415, 417 extends to ground planes 433, 435 of the second rigid part 430.

As an example, the electrical line may be configured such that in the flex part 410, the first ground line 419 is disposed parallel to and spaced apart from each of the second signal lines 411, 413 by a first clearance g2, g3, and the second ground lines 415, 417 are disposed parallel to and spaced apart from the second signal lines 411, 413 by a second clearance g1, g4.

As an example, the first clearance g2, g3 or the second clearance g1, g4 may be designed to be greater than 50 micrometers ($\mu$m) so that the characteristic impedance of the electrical line may satisfy a preset value for impedance matching with the first external element or the second external element.

As an example, the preset value considering impedance matching with the first external element or the second external element may be 50 ohms.

As an example, the width of the second signal lines 411, 413 of the flex part 410 may be substantially the same as the width of the first signal line 421.

According to an example, a rigid/flexible printed circuit board 400 included in an electronic device 101 may include a first rigid printed circuit board 420 including a first conductor layer configured such that a signal line 421 extending from a first terminal 440 branches into two first signal lines at a first junction 429; a second rigid printed circuit board 430 including a second conductor layer configured such that a signal line 431 extending from a second terminal 450 branches into two second signal lines at a second junction 439; and a flexible printed circuit board 410 including a third conductor layer having a transmission line configured to electrically connect the first conductor layer and the second conductor layer in a coplanar manner.

As an example, the third conductor layer may be configured to include two third signal lines 411, 413 provided to electrically connect the two first signal lines to the two second signal lines in one-to-one correspondence, an inner ground line 419 disposed parallel while maintaining a predetermined spacing between the two third signal lines 411, 413, a first outer ground line 415 disposed parallel to the inner ground line 419 while maintaining a predetermined spacing with one of the two third signal lines 411, 413 therebetween, and a second outer ground line 417 disposed parallel to the inner ground line 419 while maintaining a predetermined spacing with the other one of the two third signal lines 411, 413 therebetween.

As an example, it may be configured such that one end of the inner ground line 419 extends to a first via hole 427 provided to penetrate a dielectric in the first rigid printed circuit board 420 and is ground-connected to another conductor layer through the first via hole 427.

As an example, it may be configured such that the other end of the inner ground line 419 extends to a second via hole 437 provided to penetrate a dielectric in the second rigid printed circuit board 430 and is ground-connected to another conductor layer through the second via hole 437.

As an example, the first junction 429 may be included near an end of the first rigid printed circuit board 420, and the second junction 439 may be included in an end part of the second rigid printed circuit board 430.

As an example, a transmission line may be configured in the third conductor layer such that one side of the first outer ground line 415 extends to a ground line of the first rigid printed circuit board 420, and the other side of the first outer ground line 415 extends to a ground line of the second rigid printed circuit board 430.

As an example, a transmission line may be configured in the third conductor layer such that one side of the second outer ground line 417 extends to a ground line of the first rigid printed circuit board 420, and the other side of the second outer ground line 417 extends to a ground line of the second rigid printed circuit board 430.

As an example, a transmission line may be configured in the third conductor layer such that the inner ground line 419 is spaced apart from each of the two third signal lines 411, 413 by a first clearance, the first outer ground line 415 is disposed parallel to and spaced apart from one signal line 411 of the two third signal lines 411, 413 disposed between it and the inner ground line 419 by a second clearance, and the second outer ground line 417 is disposed parallel to and spaced apart from one signal line 413 of the two third signal lines 411, 413 disposed between it and the inner ground line 419 by a second clearance.

As an example, the first clearance or the second clearance may be designed to be greater than 50 micrometers ($\mu$m) so that the characteristic impedance of the flexible printed circuit board 410 may satisfy a preset value for impedance matching.

As an example, the preset value for the impedance matching may be 50 ohms.

As an example, the width of the two third signal lines 411, 413 may be substantially the same as the width of the signal line 421 extending from the first terminal 440.

As an example, the width of the two third signal lines 411, 413 may be substantially the same as the width of the signal line 431 extending from the second terminal 450.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 236 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store™), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

**Claims**

1. An electronic device (101), comprising:

   a printed circuit board (400) comprising at least one conductor layer that comprising a first rigid part (420) and a second rigid part (430) are a flex part (410) between the first rigid part and the second rigid part,
   wherein the at least one conductor layer comprises an electrical line configured to enable signal transmission between a first electrical contact point (440) in the first rigid part (420) for electrical connection to a first external element and a second electrical contact point (450) in the second rigid part (430) for electrical connection to a second external element, and

wherein the electrical line comprises such that a first signal line (421) extending from the first electrical contact point (440), branching into at least two signal lines at a first junction (429), and extending to second signal lines (411, 413) in the flex part, respectively, and a first end of a first ground line (419) between the second signal lines (411, 413) is ground-connected to another conductor layer through a first via hole (427) penetrating a dielectric in the first rigid part (420).

2. The electronic device of claim 1, wherein the second signal lines (411, 413) merge at a second junction (439) into a third signal line (431) extending to the second electrical contact point (450),

wherein the electrical line is configured such that a second end of the first ground line (419) is ground-connected to another conductor layer through a second via hole (437) penetrating a dielectric in the second rigid part (430), wherein the first junction (429) is included in the first rigid part (420), and wherein the second junction (439) is included in the second rigid part (430).

3. The electronic device of any one of claim 1 or 2, wherein in the flex part (410) comprises a second ground line (415, 417) parallel to the first ground line (419), a second line of the second signal lines (411, 413) being between the first ground line and the second ground line, and wherein the electrical line is configured such that a first side of the second ground line (415, 417) extends to a ground plane (423, 425) of the first rigid part (420), and a second side of the second ground line (415, 417) extends to a ground plane (433, 435) of the second rigid part (430).

4. The electronic device of claim 3, wherein in the flex part (410), the electrical line is configured such that the first ground line (419) is spaced apart from the second signal lines (411, 413) by a first clearance (g2, g3), and the second ground line (415, 417) is parallel to and spaced apart from the second signal line (411, 413) between the second ground line and the first ground line (419) by a second clearance (g1, g4), and wherein the first clearance (g2, g3) or the second clearance (g1, g4) is greater than 50 micrometers ($\mu$m) so that a characteristic impedance of the electrical line is configured to satisfy a predetermined value for impedance matching with an impedance of the first external element or an impedance of the second external element.

5. The electronic device of claim 1 or 2, wherein in the flex part (410), second ground lines (415, 417) are parallel to the first ground line (419) with each of the second signal lines (411, 413) between each of the second ground lines and the first ground line, and wherein the electrical line is configured such that a first side of the second ground lines (415, 417) extend to a ground plane (423, 425) of the first rigid part (420), and a second side of the second ground lines (415, 417) extend to a ground plane (433, 435) of the second rigid part (430).

6. The electronic device of claim 5, wherein in the flex part (410), the electrical line is configured such that the first ground line (419) is parallel to and spaced apart from each of the second signal lines (411, 413) by a first clearance (g2, g3), and the second ground lines (415, 417) are parallel to and spaced apart from the second signal lines (411, 413) by a second clearance (g1, g4), and wherein the first clearance (g2, g3) or the second clearance (g1, g4) is greater than 50 micrometers ($\mu$m) so that a characteristic impedance of the electrical line is configured to satisfy a predetermined value for impedance matching with an impedance of the first external element or an impedance of the second external element.

7. The electronic device of claim 4 or 6, wherein the characteristic impedance is 50 ohms.

8. The electronic device of any one of claims 1 to 7, wherein a width of the second signal lines (411, 413) in the flex part (410) is same as a width of the first signal line (421).

9. A rigid/flexible printed circuit board (400) included in an electronic device (101), comprising:

a first rigid printed circuit board (420) comprising a first conductor layer that comprises a signal line (421) extending from a first terminal (440) and branching into two first signal lines at a first junction (429); a second rigid printed circuit board (430) comprising a second conductor layer that comprises a signal line (431) extending from a second terminal (450) and branching into two second signal lines at a second junction (439); and a flexible printed circuit board (410) comprising a third conductor layer comprising a transmission line configured to electrically connect the first conductor layer and the second conductor layer to be a coplanar to each other, wherein the third conductor layer comprises:

two third signal lines (411, 413) configured to electrically connect the two first signal lines to the two second signal lines in one-to-one correspondence;

an inner ground line (419) parallel while maintaining a predetermined spacing with the two third signal lines (411, 413);

a first outer ground line (415) parallel to the inner ground line (419) and maintaining a predetermined spacing with one of the two third signal lines (411, 413) between the first outer ground line and the inner ground line; and

a second outer ground line (417) disposed parallel to the inner ground line (419) and maintaining a predetermined spacing with another one of the two third signal lines (411, 413) between the first outer ground line and the inner ground line.

10. The rigid/flexible printed circuit board of claim 9, wherein a first end of the inner ground line (419) extends to a first via hole (427) penetrating a dielectric in the first rigid printed circuit board (420) and ground-connected to another conductor layer through the first via hole (427),

wherein a second end of the inner ground line (419) extends to a second via hole (437) penetrating a dielectric in the second rigid printed circuit board (430) and ground-connected to another conductor layer through the second via hole (437), and

wherein the first junction (429) is included within a predetermined distance from an end of the first rigid printed circuit board (420), and the second junction (439) is included in an end part of the second rigid printed circuit board (430).

11. The rigid/flexible printed circuit board of claim 9 or 10, wherein the transmission line in the third conductor layer comprises a first side of the first outer ground line (415) extends to a ground line of the first rigid printed circuit board (420), and a second side of the first outer ground line (415) extends to a ground line of the second rigid printed circuit board (430), and a first side of the second outer ground line (417) extends to the ground line of the first rigid printed circuit board (420), and a second side of the second outer ground line (417) extends to the ground line of the second rigid printed circuit board (430).

12. The rigid/flexible printed circuit board of any one of claims 9 to 11, wherein the inner ground line (419) is spaced apart from each of the two third signal lines (411, 413) by a first clearance, and the first outer ground line (415) is parallel to and spaced apart from a third signal line (411) of the two third signal lines (411, 413) between the first outer ground line and the inner ground line (419) by a second clearance, and the second outer ground line (417) is parallel to and spaced apart from a third signal line (413) of the two third signal lines (411, 413) between the second outer ground line and the inner ground line (419) by a second clearance.

13. The rigid/flexible printed circuit board of claim 12, wherein the first clearance or the second clearance is greater than 50 micrometers ($\mu$m) so that a characteristic impedance of the flexible printed circuit board (410) is configured to satisfy a preset value for impedance matching.

14. The rigid/flexible printed circuit board of claim 13, wherein the preset value for the impedance matching is 50 ohms.

15. The rigid/flexible printed circuit board of any one of claims 9 to 14, wherein a width of the two third signal lines (411, 413) is same as a width of the signal line (421) extending from the first terminal (440), and the width of the two third signal lines (411, 413) is same as a width of the signal line (431) extending from the second terminal (450).

# FIG.1

EP 4 694 582 A1

# FIG.2

220

210

Second PCB

225

PCB-Module
Interface(240)

217

PCB-Module
Interface(250)

230

First PCB

Third PCB

219

235

# FIG.3

300

323

GROUND PLANE
(330)

CONDUCTOR
(320)

GROUND PLANE
(340)

L

T

H

321

G

W

G

DIELECTRIC($\varepsilon_r$)(310)

# FIG.4

# *FIG.5*

# *FIG.6*

# FIG.7A

# FIG.7B

# FIG.8A

# FIG.8B

# FIG.9

# EP 4 694 582 A1

## INTERNATIONAL SEARCH REPORT

| | International application No. |
|---|---|
| | **PCT/KR2024/004653** |

**A. CLASSIFICATION OF SUBJECT MATTER**

**H05K 1/02**(2006.01)i; **H05K 1/11**(2006.01)i; **H05K 3/46**(2006.01)i; **H01P 1/201**(2006.01)i

According to International Patent Classification (IPC) or to both national classification and IPC

**B. FIELDS SEARCHED**

Minimum documentation searched (classification system followed by classification symbols)

H05K 1/02(2006.01); G02B 6/10(2006.01); H01Q 1/38(2006.01); H04M 1/02(2006.01); H05K 1/03(2006.01); H05K 1/14(2006.01); H05K 3/46(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 연성 인쇄회로기판(flexible printed circuit board), 경성 인쇄회로기판(rigid printed circuit board), 신호배선(signal wiring), 접지배선(ground wiring), 비아홀(via hole)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2009-0127604 A (SAMSUNG ELECTRO-MECHANICS CO., LTD.) 14 December 2009 (2009-12-14)<br>See paragraphs [0002]-[0041]; claim 2; and figure 3. | 1-6,9-11 |
| Y | KR 10-2010-0011584 A (SAMSUNG ELECTRO-MECHANICS CO., LTD.) 03 February 2010 (2010-02-03)<br>See paragraphs [0016]-[0017]; and figure 2. | 1-6,10 |
| Y | KR 10-2022-0152023 A (SAMSUNG ELECTRONICS CO., LTD.) 15 November 2022 (2022-11-15)<br>See paragraph [0152]; and figures 7-8. | 4,6,9-11 |
| A | KR 10-2017-0140691 A (SAMSUNG ELECTRONICS CO., LTD.) 21 December 2017 (2017-12-21)<br>See claim 1; and figures 1-2. | 1-6,9-11 |
| A | US 2007-0227768 A1 (SHIN, Sang-Chul) 04 October 2007 (2007-10-04)<br>See claim 1; and figures 5-12. | 1-6,9-11 |

☐ Further documents are listed in the continuation of Box C.   ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **03 July 2024** | **03 July 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

| International application No. |
| --- |
| **PCT/KR2024/004653** |

**Box No. II       Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☑ Claims Nos.: **13-14**
   because they relate to parts of the international application that do not comply with the prescribed requirements to such an extent that no meaningful international search can be carried out, specifically:

   Claims 13-14 refer to claims violating the manner of referring to multiple dependent claims (PCT Rule 6.4(a)), and thus are unclear.

3. ☑ Claims Nos.: **7-8, 12, 15**
   because they are dependent claims and are not drafted in accordance with the second and third sentences of Rule 6.4(a).

Form PCT/ISA/210 (continuation of first sheet) (July 2022)

**INTERNATIONAL SEARCH REPORT**
Information on patent family members

International application No.

**PCT/KR2024/004653**

| Patent document cited in search report | | | Publication date (day/month/year) | Patent family member(s) | | | Publication date (day/month/year) |
|---|---|---|---|---|---|---|---|
| KR | 10-2009-0127604 | A | 14 December 2009 | KR | 10-0969436 | B1 | 14 July 2010 |
| KR | 10-2010-0011584 | A | 03 February 2010 | | None | | |
| KR | 10-2022-0152023 | A | 15 November 2022 | EP | 4319505 | A1 | 07 February 2024 |
| | | | | US | 2024-0073307 | A1 | 29 February 2024 |
| | | | | WO | 2022-234959 | A1 | 10 November 2022 |
| KR | 10-2017-0140691 | A | 21 December 2017 | AU | 2017-283939 | A1 | 13 December 2018 |
| | | | | AU | 2017-283939 | B2 | 05 August 2021 |
| | | | | EP | 3455904 | A1 | 20 March 2019 |
| | | | | EP | 3455904 | A4 | 04 March 2020 |
| | | | | KR | 10-2023-0110222 | A | 21 July 2023 |
| | | | | KR | 10-2553177 | B1 | 10 July 2023 |
| | | | | US | 10727568 | B2 | 28 July 2020 |
| | | | | US | 10978789 | B2 | 13 April 2021 |
| | | | | US | 11569565 | B2 | 31 January 2023 |
| | | | | US | 11749880 | B2 | 05 September 2023 |
| | | | | US | 2017-0358847 | A1 | 14 December 2017 |
| | | | | US | 2020-0358166 | A1 | 12 November 2020 |
| | | | | US | 2021-0226320 | A1 | 22 July 2021 |
| | | | | US | 2023-0134315 | A1 | 04 May 2023 |
| | | | | US | 2023-0411832 | A1 | 21 December 2023 |
| | | | | WO | 2017-217714 | A1 | 21 December 2017 |
| US | 2007-0227768 | A1 | 04 October 2007 | EP | 1841296 | A1 | 03 October 2007 |
| | | | | EP | 1841296 | B1 | 15 December 2010 |
| | | | | JP | 2007-273981 | A | 18 October 2007 |
| | | | | JP | 5154811 | B2 | 27 February 2013 |
| | | | | KR | 10-0752660 | B1 | 29 August 2007 |
| | | | | US | 7869164 | B2 | 11 January 2011 |

Form PCT/ISA/210 (patent family annex) (July 2022)